# EUROPÄISCHE PATENTSCHRIFT

(11) **EP 2 884 534 B1**
(45) Veröffentlichungstag und Bekanntmachung des Hinweises auf die Patenterteilung: **17.10.2018**
(21) Anmeldenummer: 14186235.9
(22) Anmeldetag: 24.09.2014
(51) Int. Cl.: H01L 25/07, H01L 23/057, H01L 23/10, H01L 23/498

(54) **Leistungshalbleitereinrichtung**
Power semiconductor device
Dispositif semi-conducteur de puissance

(30) Priorität: 10.12.2013 DE 102013113764
(43) Veröffentlichungstag der Anmeldung: 17.06.2015
(73) Patentinhaber: SEMIKRON Elektronik GmbH & Co. KG, 90431 Nürnberg (DE)
(72) Erfinder: Lemke, Peter, 91126 Schwabach (DE)

(56) Entgegenhaltungen:
- DE-A1-102007 007 224
- DE-B3-102005 036 105

## Beschreibung

Die Erfindung betrifft eine Leistungshalbleitereinrichtung.

Bei aus dem Stand der Technik bekannten Leistungshalbleitereinrichtungen, wie z.B. aus der EP 2 525 404 A1 bekannt, sind im Allgemeinen auf einem Substrat Leistungshalbleiterbauelemente, wie z.B. Leistungshalbleiterschalter und Dioden angeordnet und mittels einer Leiterschicht des Substrats, sowie Bonddrähten und/oder einem Folienverbund miteinander elektrisch leitend verbunden. Die Leistungshalbleiterschalter liegen dabei im Allgemeinen in Form von Transistoren, wie z.B. IGBTs (Insulated Gate Bipolar Transistor) oder MOSFETs (Metal Oxide Semiconductor Field Effect Transistor), oder in Form von Thyristoren vor.

Die auf dem Substrat angeordneten Leistungshalbleiterbauelemente sind dabei häufig elektrisch zu einer einzelnen oder mehreren sogenannten Halbbrückenschaltungen verschalten, die z.B. zum Gleich- und Wechselrichten von elektrischen Spannungen und Strömen verwendet werden.

Technikübliche Leistungshalbleitereinrichtungen weisen zur Führung von Lastströmen Lastanschlusselemente auf, mit Hilfe derer die Leistungshalbleitereinrichtungen elektrisch leitend mit externen Komponenten verbunden werden können. Die Lastströme weisen dabei in der Regel, im Gegensatz zu Hilfsströmen, welche z.B. zur Ansteuerung der Leistungshalbleiterschalter dienen, eine hohe Stromstärke auf. Die Lastanschlusselemente müssen im Allgemeinen durch das Gehäuse der Leistungshalbleitereinrichtung geführt werden. An Leistungshalbleitereinrichtungen wird dabei oftmals die Anforderung gestellt z.B. gegen Spritzwasser (z.B. IP54) geschützt zu sein, so dass die Lastanschlusselemente gegen das Gehäuse abgedichtet sein müssen. Bei techniküblichen Leistungshalbleitereinrichtungen werden die Lastanschlusselemente durch eine Ausnehmung des Gehäuse geführt und mittels einer Silikondichtmasse und/oder weiteren Dichtelementen gegen das Gehäuse abgedichtet. Infolge der techniküblichen rechteeckförmigen Kontur der Lastanschlusselemente sind an den Kanten der Lastanschlusselemente oftmals kleine Bereiche vorhanden an denen kein Dichtmaterial vorhanden ist oder es bilden sich solche Bereiche im Laufe der Zeit aus. Infolge davon sind die Lastanschlusselemente nicht mehr ausreichend gegen das Gehäuse abgedichtet.

Aus der DE 10 2007 007 224 A1 ist ein Leistungshalbleitermodul mit einem Gehäuse in welchem Lastanschlusselemente angeordnet sind, die Kontakteinrichtungen aufweisen, die in Gehäusemulden des Gehäuses angeordnet sind, die an einer zugehörigen Seitenwand des Gehäuses ausgebildet sind, bekannt.

Aus der DE 10 2005 036 105 B3 ist ein elektrisches Bauteil mit mindestens einer Stromschiene, die zwischen einem ersten und einem zweiten Gehäuseteil vorgesehen ist, und die mit einem äußeren Stromanschlusselement kontaktierbar ist, wobei die Stromschiene mit einer aus ihrer Grundfläche herausragenden Noppe ausgebildet ist, die einen kreisrunden Kontaktringstirnflächenabschnitt mit einem Durchgangsloch und einen kreiszylindrischen Mantelabschnitt aufweist, wobei der Kontaktringstirnflächenabschnitt von der Grundfläche eine derartige Höhenabmessung besitzt, dass die Noppe mit einer Kontaktfläche des Kontaktringstirnflächenabschnittes aus einem Loch im zweiten Gehäuseteil vorsteht, bekannt.

Es ist Aufgabe der Erfindung eine Leistungshalbleitereinrichtung zu schaffen bei der mindestens ein Lastanschlusselement zuverlässig gegen das Gehäuse der Leistungshalbleitereinrichtung abgedichtet ist.

Diese Aufgabe wird gelöst durch eine Leistungshalbleitereinrichtung mit einem Substrat und mit auf dem Substrat angeordneten und mit dem Substrat verbundenen Leistungshalbleiterbauelementen, wobei die Leistungshalbleitereinrichtung ein Gehäuse aufweist, das eine erste Ausnehmung aufweisendes erstes Gehäuseteil und ein zweites Gehäuseteil aufweist, wobei das zweite Gehäuseteil derart zum ersten Gehäuseteil angeordnet ist, dass sich durch die erste Ausnehmung eine Öffnung im Gehäuse ausbildet, wobei die Leistungshalbleitereinrichtung zur elektrischen Kontaktierung der Leistungshalbleitereinrichtung ein elektrisch leitendes Lastanschlusselement aufweist, das einen außerhalb des Gehäuses angeordneten Außenanschlussabschnitt und einen innerhalb des Gehäuses angeordneten Innenanschlussabschnitt und einen durch die Öffnung durchlaufenden Durchführungsabschnitt aufweist, wobei der Durchführungsabschnitt einen lateral in Richtung einer ersten Außenkante des Durchführungsabschnitts spitz zulaufenden ersten Außenkantenbereich und einen lateral in Richtung einer zweiten Außenkante des Durchführungsabschnitts spitz zulaufenden zweiten Außenkantenbereich aufweist, wobei der erste und zweite Außenkantenbereich voneinander abgewandt angeordnet sind und die erste Außenkante im Bereich des lateralen ersten Endes der Öffnung und die zweite Außenkante im Bereich des lateralen zweiten Endes der Öffnung angeordnet ist, wobei zwischen dem ersten Gehäuseteil und dem Durchführungsabschnitt ein erster Abschnitt eines ersten Dichtelements und zwischen dem zweiten Gehäuseteil und dem Durchführungsabschnitt ein erster Abschnitt eines zweiten Dichtelements angeordnet ist, wobei das erste und zweite Dichtelement lateral von der ersten und zweiten Außenkante einen Kontakt zueinander aufweisen, wobei das erste Dichtelement den Durchführungsabschnitt gegen das erste Gehäuseteil abdichtet und das zweite Dichtelement den Durchführungsabschnitt gegen das zweite Gehäuseteil abdichtet.

Vorteilhafte Ausbildungen der Erfindung ergeben sich aus den abhängigen Ansprüchen.

Es erweist sich als vorteilhaft, wenn die geometrische Form des Durchführungsabschnitts durch eine dem ersten Gehäuseteil zugewandte Außenfläche des Durchführungsabschnitts und durch eine dem zweiten Gehäuseteil zugewandte Außenfläche des Durchführungsabschnitts gebildet wird, wobei die dem ersten Gehäuseteil zugewandte Außenfläche im Bereich zwischen erster und zweiter Außenkante in Richtung von der ersten zur zweiten Außenkante einen zwei Wendepunkte aufweisenden Kurvenverlauf aufweist, wobei der erste Wendepunkt zwischen erster Außenkante und einem Punkt des Kurvenverlaufs, dessen senkrechte Entfernung zur ersten Außenkante dem halben Abstand der ersten und zweiten Außenkante voneinander entspricht, angeordnet ist, wobei der zweite Wendepunkt zwischen zweiter Außenkante und dem Punkt des Kurvenverlaufs dessen senkrechte Entfernung zur ersten Außenkante dem halben Abstand der ersten und zweiten Außenkante voneinander entspricht, angeordnet ist. Hierdurch weist die geometrische Form des Durchführungsabschnitts einen Verlauf auf, an den sich das erste und zweite Dichtelement gut anschmiegen kann, so dass eine besonders zuverlässige Abdichtung des Lastanschlusselements gegen das Gehäuse der Leistungshalbleitereinrichtung erzielt wird.

Es erweist sich als vorteilhaft, wenn die geometrische Form des Durchführungsabschnitts bezüglich einer gedachten in Y-Richtung und Z-Richtung sich erstreckenden und von der ersten und zweiten Außenkante identisch beanstandeten ersten Ebene spiegelsymmetrisch ausgebildet ist. Hierdurch kann sich das erste und zweite Dichtelement gut an die Öffnung und an den Durchführungsabschnitt anschmiegen, so dass eine sehr zuverlässige Abdichtung des Lastanschlusselements gegen das Gehäuse der Leistungshalbleitereinrichtung erzielt wird.

Es erweist sich als vorteilhaft, wenn das zweite Gehäuseteil eine zweite Ausnehmung aufweist, wobei das zweite Gehäuseteil derart zum ersten Gehäuseteil angeordnet ist, dass die zweite Ausnehmung über der ersten Ausnehmung angeordnet ist und sich durch die erste und zweite Ausnehmung die Öffnung im Gehäuse ausbildet. Hierdurch wird eine sehr zuverlässige Abdichtung des Lastanschlusselements gegen das Gehäuse der Leistungshalbleitereinrichtung erzielt.

Weiterhin erweist es sich als vorteilhaft, wenn die geometrische Form des Durchführungsabschnitts durch eine dem ersten Gehäuseteil zugewandte Außenfläche des Durchführungsabschnitts und durch eine dem zweiten Gehäuseteil zugewandte Außenfläche des Durchführungsabschnitts gebildet wird wobei die dem ersten Gehäuseteil zugewandte Außenfläche und die dem zweiten Gehäuseteil zugewandte Außenfläche im Bereich zwischen erster und zweiter Außenkante in Richtung von der ersten zur zweiten Außenkante einen zwei Wendepunkte aufweisenden jeweiligen Kurvenverlauf aufweist, wobei der jeweilige erste Wendepunkt zwischen erster Außenkante und einem Punkt des jeweiligen Kurvenverlaufs, dessen senkrechte Entfernung zur ersten Außenkante dem halben Abstand der ersten und zweiten Außenkante voneinander entspricht, angeordnet ist, wobei der jeweilige zweite Wendepunkt zwischen zweiter Außenkante und dem Punkt des jeweiligen Kurvenverlaufs dessen senkrechte Entfernung zur ersten Außenkante dem halben Abstand der ersten und zweiten Außenkante voneinander entspricht, angeordnet ist. Hierdurch weist die geometrische Form des Durchführungsabschnitts einen Verlauf auf, an den sich das erste und zweite Dichtelement gut anschmiegen kann, so dass eine besonders zuverlässige Abdichtung des Lastanschlusselements gegen das Gehäuse der Leistungshalbleitereinrichtung erzielt wird.

Ferner erweist es sich als vorteilhaft, wenn die geometrische Form des Durchführungsabschnitts bezüglich einer gedachten in X-Richtung und Z-Richtung sich erstreckenden durch die ersten und zweiten Außenkanten verlaufenden zweiten Ebene spiegelsymmetrisch ausgebildet ist, und bezüglich einer gedachten in Y-Richtung und Z-Richtung sich erstreckenden und von der ersten und zweiten Außenkante identisch beanstandeten ersten Ebene spiegelsymmetrisch ausgebildet ist. Hierdurch kann sich das erste und zweite Dichtelement besonders gut an die Öffnung und an den Durchführungsabschnitt anschmiegen, so dass eine besonders zuverlässige Abdichtung des Lastanschlusselements gegen das Gehäuse der Leistungshalbleitereinrichtung erzielt wird.

Es erweist sich als vorteilhaft, wenn, die geometrische Form des Durchführungsabschnitts durch eine dem ersten Gehäuseteil zugewandte Außenfläche des Durchführungsabschnitts und durch eine dem zweiten Gehäuseteil zugewandte Außenfläche des Durchführungsabschnitts gebildet wird, wobei die dem ersten Gehäuseteil zugewandte und die dem zweiten Gehäuseteil zugewandte Außenfläche im Bereich zwischen erster und zweiter Außenkante in Richtung von der ersten zur zweiten Außenkante einen stetig differenzierbaren Kurvenverlauf aufweist, da dann die jeweilige Außenfläche im Bereich zwischen erster und zweiter Außenkante keine Kanten aufweist an denen die Gefahr besteht, dass kein Dichtmaterial vorhanden ist.

Ferner erweist es sich als vorteilhaft, wenn die geometrische Form des Durchführungsabschnitts durch eine dem ersten Gehäuseteil zugewandte Außenfläche des Durchführungsabschnitts und durch eine dem zweiten Gehäuseteil zugewandte Außenfläche des Durchführungsabschnitts gebildet wird, wobei die dem ersten Gehäuseteil zugewandte Außenfläche und die dem zweiten Gehäuseteil zugewandte Außenfläche an der ersten und zweiten Außenkante einen Wickel von maximal 30° zueinander aufweisen, da dann mit besonders hoher Sicherheit keine Bereiche vorhanden sind an denen kein Dichtmaterial vorhanden ist bzw. sich solche Bereiche im Laufe der Zeit ausbilden.

Weiterhin erweist es sich als vorteilhaft, wenn die geometrische Form der Öffnung und die geometrischen Form des Durchführungsabschnitts 2b zueinander korrespondierend ausgebildet sind. Hierdurch kann sich das erste und zweite Dichtelement besonders gut an die Öffnung und an den Durchführungsabschnitt anschmiegen, so dass eine besonders zuverlässige Abdichtung des Lastanschlusselements gegen das Gehäuse der Leistungshalbleitereinrichtung erzielt wird.

Weiterhin erweist es sich als vorteilhaft, wenn die erste und zweite Außenkante des Durchführungsabschnitts gegenüber der an den Durchführungsabschnitt angrenzenden lateralen Kontur des Innanschlussabschnitts und des Außenanschlussabschnitts zurückgesetzt ist. Durch die Zurücksetzung der Außenkanten des Durchführungsabschnitts können Beschädigungen der Außenkanten und Verletzungen von Personen durch die Außenkanten zuverlässig verhindert werden.

Weiterhin erweist es sich als vorteilhaft, wenn das erste Dichtelement stoffschlüssig mit dem ersten Gehäuseteil verbunden ist und/oder das zweite Dichtelement stoffschlüssig mit dem zweiten Gehäuseteil verbunden ist, da die Leistungshalbleitereinrichtung hierdurch besonders einfach aufgebaut ist.

Ferner erweist es sich als vorteilhaft, wenn, die geometrische Form des Durchführungsabschnitts durch eine dem ersten Gehäuseteil zugewandte Außenfläche des Durchführungsabschnitts und durch eine dem zweiten Gehäuseteil zugewandte Außenfläche des Durchführungsabschnitts gebildet wird, wobei die dem ersten Gehäuseteil zugewandte Außenfläche und/oder die dem zweiten Gehäuseteil zugewandte Außenfläche fledermausgaubenförmig ausgebildet ist, da dann sich das erste und zweite Dichtelements besonders gut an die Öffnung und an den Durchführungsabschnitt anschmiegen kann.

Ausführungsbeispiele der Erfindung sind in den Figuren dargestellt und werden im Folgenden näher erläutert. Dabei zeigen:
- FIG 1: eine perspektivische Darstellung einer erfindungsgemäßen Leistungshalbleitereinrichtung mit abgenommen zweiten Gehäuseteil,
- FIG 2: eine schematisierte Schnittdarstellung eines Substrats der erfindungsgemäßen Leistungshalbleitereinrichtung und der mit dem Substrat verbundenen Elemente der Leistungshalbleitereinrichtung,
- FIG 3: eine Schnittdarstellung eines Ausschnitts eines ersten und zweiten Gehäuseteils der erfindungsgemäßen Leistungshalbleitereinrichtung, wobei die zwischen dem ersten und zweiten Gehäuseteil angeordneten Elemente nicht dargestellt sind,
- FIG 4: eine Schnittdarstellung des in FIG 3 dargestellten Ausschnitts des ersten und zweiten Gehäuseteils, wobei die zwischen dem ersten und zweiten Gehäuseteil angeordneten Elemente mit dargestellt sind,
- FIG 5: eine schematisiere Ansicht von oben auf das Lastanschlusselement,
- FIG 6: eine Schnittdarstellung des Lastanschlusselements und
- FIG 7: eine Schnittdarstellung eines ersten und zweiten Gehäuseteils einer weiteren Ausbildung einer erfindungsgemäßen Leistungshalbleitereinrichtung, wobei die zwischen dem ersten und zweiten Gehäuseteil angeordneten Elemente mit dargestellt sind.

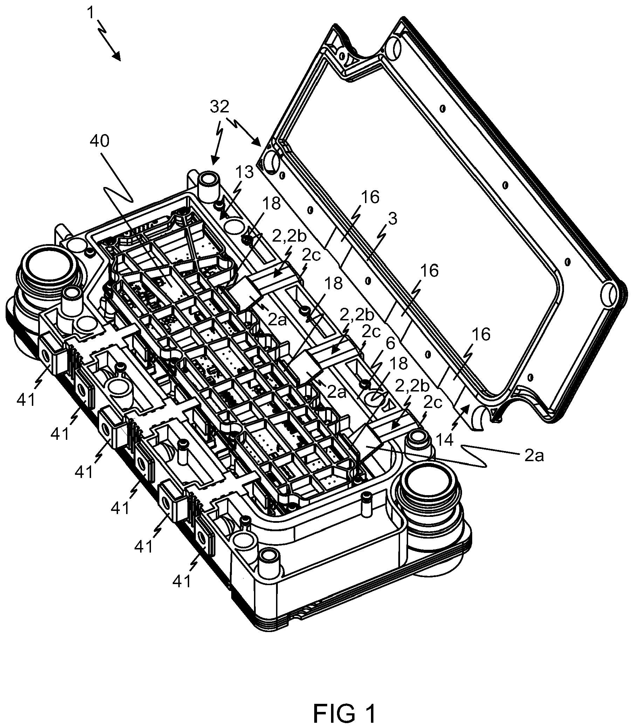

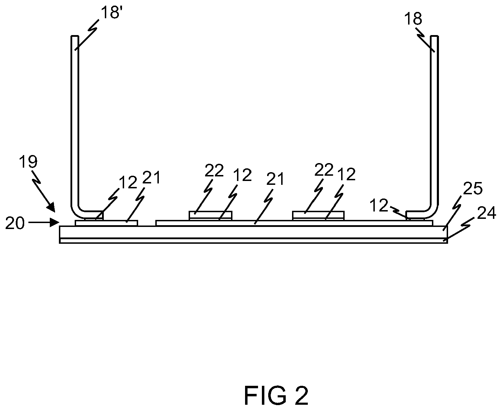

In FIG 1 ist einer perspektivische Darstellung einer erfindungsgemäßen Leistungshalbleitereinrichtung 1 mit abgenommen zweiten Gehäuseteil 14 dargestellt. In FIG 2 ist eine schematisierte Schnittdarstellung eines Substrats 19 der erfindungsgemäßen Leistungshalbleitereinrichtung 1 und der mit dem Substrat 19 verbundenen Elemente der Leistungshalbleitereinrichtung 1 dargestellt. Die Leistungshalbleitereinrichtung 1 weist ein Gehäuse 32 auf, das ein erstes Gehäuseteil 13 aufweist, das vorzugsweise die Leistungshalbleiterbauelemente 22 des Leistungshalbleitereinrichtung 1 seitlich umschließt. Die Leistungshalbleitereinrichtung 1 weist beim Ausführungsbeispiel zur elektrischen Kontaktierung der Leistungshalbleitereinrichtung mit externen elektrischen Leitungseinrichtungen, wie z.B. elektrischen leitenden Schienen oder Kabeln drei Lastanschlusselemente 2 auf. Mittels der Lastanschlusselemente 2 werden Lastströme durch ein Gehäuse des Leistungshalbleitereinrichtung 1 geführt. Beim Ausführungsbeispiel liegen die Lastströme in Form von Wechselströmen vor.

Es sei an dieser Stelle angemerkt, das im Rahmen des Ausführungsbeispiels mittels der Leistungshalbleitereinrichtung 1 eine Gleichspannung in eine 3-phasige Wechselspannung wechselgerichtet bzw. eine 3-phasige Wechselspannung in eine Gleichspannung gleichgerichtet wird. Die folgende Beschreibung beschreibt dabei beispielhaft den Aufbau der Leitungshalbleitereinrichtung 1, hinsichtlich eines Substrats und der dem Substrat zugeordneten Elemente, bezüglich der Erzeugung einer 1-phasigen Wechselspannung. Das Substrat 19 bzw. die in FIG 2 dargestellte Anordnung zur Erzeugung der 1-phasigen Wechselspannung ist dabei in identischer Ausführung dreifach vorhanden, so dass, wie schon oben beschrieben, beim Ausführungsbeispiel von der Leitungshalbleitereinrichtung 1 aus einer Gleichspannung eine 3-phasige Wechselspannung erzeugt wird bzw. eine 3-phasige Wechselspannung in eine Gleichspannung gleichgerichtet wird. Das Leistungshalbleitereinrichtung 1 weist ein Substrat 19 und auf dem Substrat 19 angeordnete und mit dem Substrat 19 verbundene Leistungshalbleiterbauelemente 22 auf. Das jeweilige Leistungshalbleiterbauelement liegt vorzugsweise in Form eines Leistungshalbleiterschalters oder einer Diode vor. Die Leistungshalbleiterschalter liegen dabei im Allgemeinen in Form von Transistoren, wie z.B. IGBTs (Insulated Gate Bipolar Transistor) oder MOSFETs (Metal Oxide Semiconductor Field Effect Transistor), oder in Form von Thyristoren vor.

Das Substrat 19 weist einen Isolierstoffkörper 25 und eine auf einer ersten Seite des Isolierstoffkörpers 25 angeordnete und mit dem Isolierstoffkörper 25 verbundene elektrisch leitende strukturierte erste Leitungsschicht 20 auf, die im Rahmen des Ausführungsbeispiels Leiterbahnen 21 ausbildet. Vorzugsweise weist das Substrat 19 eine elektrisch leitende, vorzugsweise unstrukturierte zweite Leitungsschicht 24 auf, wobei der Isolierstoffkörper 25 zwischen der strukturierten ersten Leitungsschicht 20 und der zweiten Leitungsschicht 24 angeordnet ist. Das Substrat 19 kann z.B. in Form eines Direct Copper Bonded Substrats (DCB-Substrat) oder in Form eines Insulated Metal Substrats (IMS) vorliegen.

Weiterhin weist die Leistungshalbleitereinrichtung 1 ein elektrisch leitendes Verbindungselement 18 auf, das das Substrat 19, genauer ausgedrückt die erste Leitungsschicht 20 des Substrats 19 mit dem elektrisch leitenden Lastanschlusselement 2 verbindet. Wie in FIG 1 dargestellt ist beim Ausführungsbeispiel das Lastanschlusselement 2 mit dem Verbindungselement 18 verbunden. Das Lastanschlusselement 2 ist elektrisch leitend mit mindestens einem Leistungshalbleiterbauelement 22 verbunden. Das Lastanschlusselement 2 kann aber z.B. auch direkt mit dem Substrat 19 oder mit einem Leistungshalbleiterbauelement 22 verbunden sein. Weiterhin weist die Leistungshalbleitereinrichtung 1 beim Ausführungsbeispiel zwei elektrisch leitende weitere Verbindungselemente 18' auf, die das Substrat 19, genauer ausgedrückt die erste Leitungsschicht 20 des Substrats 19 mit zugeordneten elektrisch leitenden Gleichspannungslastanschlusselementen 41 verbinden. Vorzugsweise ist die Verbindung zwischen den oben genannten Elementen jeweilig als stoffschlüssige (z.B. Löt- oder Sinterverbindung) oder als kraftschlüssige Verbindung realisiert, wobei in FIG 2 die jeweilige Verbindungsschicht mit dem Bezugszeichen 12 versehen ist. Die Lastströme, welche durch das Lastanschlusselement 2 und durch die Gleichspannungslastanschlusselemente 41 fließen, weisen dabei in der Regel, im Gegensatz zu Hilfsströmen, welche z.B. zur Ansteuerung der Leistungshalbleiterbauelemente dienen, wenn die Leistungshalbleiterbauelemente als Leistungshalbleiterschalter ausgebildet sind, eine hohe Stromstärke auf.

Es sei weiterhin angemerkt, dass die Leistungshalbleiterbauelemente 22 an Ihrer dem Substrat 19 abgewandten Seite, mittels z.B. Bonddrähten und/oder einem Folienverbund miteinander und mit den Leiterbahnen 21 des Substrats 19, entsprechend der gewünschten elektrischen Schaltung, welche die Leistungshalbleitereinrichtung 1 realisieren soll, elektrisch leitend miteinander verbunden sind. Der Übersichtlichkeit halber sind diese elektrischen Verbindungen in FIG 2 nicht dargestellt.

Wie in FIG 1 dargestellt, weist das Leistungshalbleitereinrichtung 1 vorzugsweise eine Leiterplatte 40 auf, auf der die zur Ansteuerung der Leistungshalbleiterschalter 22 der Leistungshalbleitereinrichtung 1 benötigten elektrischen Treiberschaltungen realisiert sind.

Die Leistungshalbleitereinrichtung 1 weist ein Gehäuse 32 auf, das ein erstes Gehäuseteil 13 und ein zweites Gehäuseteil 14 aufweist. Das erste und zweite Gehäuseteil 13 und 14 bestehen vorzugsweise aus einem Thermoplast. Im Rahmen des Ausführungsbeispiels umschließt das erste Gehäuseteil 13 seitlich die Leistungshalbleiterbauelemente 22 des Leistungshalbleitereinrichtung 1. Das zweite Gehäuseteil 14 ist vorzugsweise als Deckel ausgebildet. Im Rahmen des Ausführungsbeispiels wird das zweite Gehäuseteils 14 mit dem ersten Gehäuseteil 13 mittels einer Schraubverbindung verbunden. Alternativ könnte das zweite Gehäuseteil 14 mit dem ersten Gehäuseteil 13 auch z.B. mittels einer Schnapp-Rastverbindung oder einer anderen Verbindungsart verbunden sein.

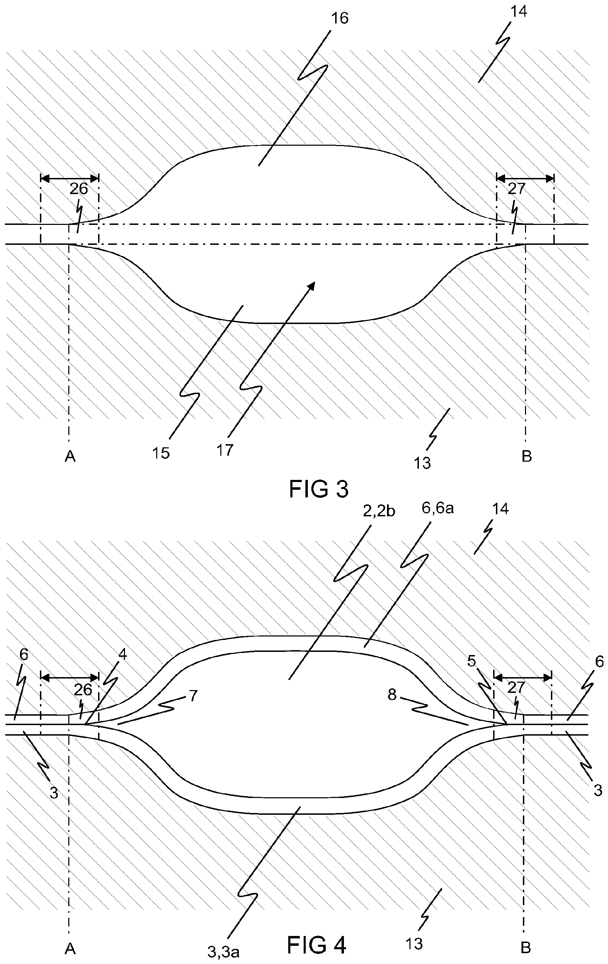

In FIG 3 ist eine Schnittdarstellung eines Ausschnitts des ersten und zweiten Gehäuseteils 13 und 14, wenn das zweite Gehäuseteil 14 mit dem ersten Gehäuseteil 13 verbunden ist, dargestellt, wobei die zwischen dem ersten und zweiten Gehäuseteil 13 und 14 angeordneten Elemente nicht dargestellt sind.

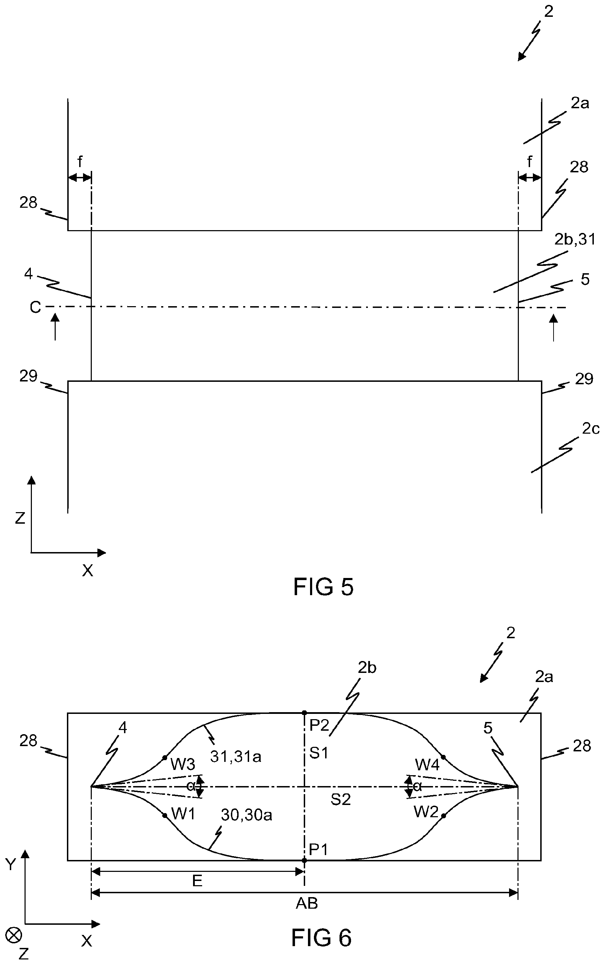

Das erste Gehäuseteil 13 weist eine erste Ausnehmung 15 und das zweite Gehäuseteil 14 eine zweite Ausnehmung 16 auf. Das zweite Gehäuseteil 14 ist derart zum ersten Gehäuseteil 13 angeordnet, dass die zweite Ausnehmung 16 über der ersten Ausnehmung 15 angeordnet ist und sich durch die erste und zweite Ausnehmung 15 und 16 eine Öffnung 17 im Gehäuse ausbildet. Die Öffnung 17 weist ein laterales erste Ende A und ein laterales zweites Ende B auf. Das laterale erste Ende A und das laterale zweite Ende B der Öffnung 17 stimmen mit den lateralen Enden der ersten und zweiten Ausnehmung überein. Die Öffnung 17 verläuft zwischen dem ersten und zweiten Ende A und B der Öffnung 17. Die laterale Richtung wird beim Ausführungsbeispiel durch die X-Richtung (siehe FIG 5 und FIG 6) gebildet.

In FIG 4 ist eine Schnittdarstellung des in FIG 3 dargestellten Ausschnitts des ersten und zweiten Gehäuseteils 13 und 14 dargestellt, wobei die zwischen dem ersten und zweiten Gehäuseteils 13 und 14 angeordneten Elemente mit dargestellt sind. In FIG 5 ist eine schematisiere Ansicht von oben auf das Lastanschlusselement 2 und in FIG 6 eine Schnittdarstellung des Lastanschlusselements 2 dargestellt, wobei der Schnitt entlang der in FIG 5 dargestellten Linie C verläuft. In FIG 5 ist dabei das Lastanschlusselements 2 in einem noch nicht abgewinkelten Zustand dargestellt, der in FIG 1 dargestellt ist.

Das Lastanschlusselement 2 weist einen außerhalb des Gehäuses 32 der Leistungshalbleitereinrichtung 1 angeordneten Außenanschlussabschnitt 2c und einen innerhalb des Gehäuses 32 der Leistungshalbleitereinrichtung 1 angeordneten Innenanschlussabschnitt 2a und einen durch die Öffnung 17 durchlaufenden Durchführungsabschnitt 2b auf. Der Durchführungsabschnitt 2b weist einen lateral in Richtung einer ersten Außenkante 4 des Durchführungsabschnitts 2b spitz zulaufenden ersten Außenkantenbereich 7 und einen lateral in Richtung einer zweiten Außenkante 5 des Durchführungsabschnitts 2b spitz zulaufenden zweiten Außenkantenbereich 8 auf. Der erste und zweite Außenkantenbereich 7 und 8 sind voneinander abgewandt angeordnet und die erste Außenkante 4 ist im Bereich 26 des lateralen ersten Endes A der Öffnung 17 und die zweite Außenkante 5 im Bereich 27 des lateralen zweiten Endes B der Öffnung 17 angeordnet. Die Ausdehnung des Bereichs 26 des lateralen ersten Endes A der Öffnung 17 und des Bereichs 27 des lateralen zweiten Endes B der Öffnung 17 ist in FIG 3 und FIG 4 mit einem jeweiligen Doppelfeil angedeutet. Der Bereich 26 bzw. 27 umfasst ein lateral etwas außerhalb der Öffnung 17 angeordnetes Gebiet und ein lateral etwas innerhalb der Öffnung 17 angeordnetes Gebiet, einschließlich des jeweiligen Endes A bzw. B der Öffnung 17.

Zwischen dem ersten Gehäuseteil 13 und dem Durchführungsabschnitt 2b ist ein erster Abschnitt 3a eines ersten Dichtelements 3 und zwischen dem zweiten Gehäuseteil 13 und dem Durchführungsabschnitt 2b ist ein erster Abschnitt 6a eines zweiten Dichtelements 6 angeordnet, wobei das erste und zweite Dichtelement 3 und 6 lateral von der ersten und zweiten Außenkante 4 und 5 einen Kontakt zueinander aufweisen. Das erste Dichtelement 3 dichtet den Durchführungsabschnitt 2b gegen das erste Gehäuseteil 13 ab und das zweite Dichtelement 6 dichtet den Durchführungsabschnitt 2b gegen das zweite Gehäuseteil 14 ab.

Das erste und zweite Dichtelement 3 und 6 bestehen vorzugsweise aus einem elastischen Material, wie z.B. Silikon oder Gummi. Das erste Dichtelement 3 kann stoffschlüssig mit dem ersten Gehäuseteil 13 verbunden sein und/oder das zweite Dichtelement 6 kann stoffschlüssig mit dem zweiten Gehäuseteil 14 verbunden sein. Alternativ kann das erste und/oder zweite Dichtelement 3 und 6 jeweilig auch in Form eines separaten Dichtelements (z.B. als Dichtring) realisiert sein, der bei der Montage der Leistungshalbleitereinrichtung 1 zwischen Durchführungsabschnitt 2b und dem jeweiligen Gehäuseteil 13 bzw. 14 gelegt wird.

Infolge des lateral nach außen in Richtung einer ersten Außenkante des Durchführungsabschnitts spitz zulaufenden ersten Außenkantenbereichs und des lateral nach außen in Richtung einer zweiten Außenkante des Durchführungsabschnitts spitz zulaufenden zweiten Außenkantenbereich sind an den Außenkanten des Durchführungsabschnitts des Lastanschlusselements keine Bereiche vorhanden an denen kein Dichtmaterial vorhanden ist bzw. es bilden sich keine solche Bereiche im Laufe der Zeit aus.

Zur Herstellung eines elektrischen Kontakts zwischen der Leistungshalbleitereinrichtung 1 und einer externen elektrischen Leitungseinrichtung, wie z.B. einer elektrisch leitenden Schiene oder einem Kabel, wird die externe elektrische Leitungseinrichtung mit dem Außenanschlussabschnitt 2c des Lastanschlusselements 2 verbunden.

Die erste und zweite Außenkante 4 und 5 weisen vorzugsweise eine scharfe Form auf.

Die erste und zweite Außenkanten 4 und 5 verlaufen in Z-Richtung (siehe FIG 6). Sie verlaufen im Rahmen des Ausführungsbeispiels parallel zueinander.

Die geometrische Form des Durchführungsabschnitts 2b wird vorzugsweise durch eine dem ersten Gehäuseteil 13 zugewandte Außenfläche 30 des Durchführungsabschnitts 2b und durch eine dem zweiten Gehäuseteil 14 zugewandte Außenfläche 31 des Durchführungsabschnitts 2b gebildet, wobei die dem ersten Gehäuseteil 13 zugewandte Außenfläche 30 des Durchführungsabschnitts 2b und die dem zweiten Gehäuseteil 14 zugewandte Außenfläche 31 des Durchführungsabschnitts 2b im Bereich zwischen erster und zweiter Außenkante 4 und 5 in Richtung von der ersten zur zweiten Außenkante einen stetig differenzierbaren Kurvenverlauf aufweist. Somit weist die Außenfläche 30 und 31 des Durchführungsabschnitts 2b im Bereich zwischen erster und zweiter Außenkante 4 und 5 in Richtung von der ersten zur zweiten Außenkante keine Kanten auf an denen die Gefahr besteht, dass kein Dichtmaterial vorhanden ist.

Die dem ersten Gehäuseteil 13 zugewandte Außenfläche 30 des Durchführungsabschnitts 2b und die dem zweiten Gehäuseteil 14 zugewandte Außenfläche 31 des Durchführungsabschnitts 2b weist vorzugsweise im Bereich zwischen erster und zweiter Außenkante 4 und 5 in Richtung von der ersten zur zweiten Außenkante einen zwei Wendepunkte aufweisenden jeweiligen Kurvenverlauf 30a bzw. 31a auf, wobei der jeweilige erste Wendepunkt W1 bzw. W3 zwischen erster Außenkante 4 und einem Punkt P1 bzw. P2 des jeweiligen Kurvenverlaufs 30a bzw. 31a, dessen senkrechte Entfernung E zur ersten Außenkante 4 dem halben Abstand AB der ersten und zweiten Außenkante 4 und 5 voneinander entspricht, angeordnet ist, wobei der jeweilige zweite Wendepunkt W2 bzw. W4 zwischen zweiter Außenkante 5 und dem Punkt P1 bzw. P2 des jeweiligen Kurvenverlaufs 30a bzw. 31a dessen senkrechte Entfernung E zur ersten Außenkante 4 dem halben Abstand E der ersten und zweiten Außenkante 4 und 5 voneinander entspricht, angeordnet ist. Die Wendepunkte sind dabei die Punkte W1, W2 bzw. W3, W4 auf dem jeweiligen Kurvenverlauf 30a bzw. 31a bei denen der Betrag der Steigung des jeweiligen Kurvenverlauf 30a bzw. 31a ein lokales Maximum aufweist, d.h. im Nahbereich links und rechts des jeweiligen Wendepunkts sinkt der Betrag der Steigung des jeweiligen Kurvenverlauf 30a bzw. 31a.

Im Rahmen des Ausführungsbeispiels weisen die dem ersten Gehäuseteil 13 zugewandte Außenfläche 30 des Durchführungsabschnitts 2b und die dem zweiten Gehäuseteil 14 zugewandte Außenfläche 31 des Durchführungsabschnitts 2b an der ersten und zweiten Außenkante 4 und 5 einen Wickel α von maximal 30°, insbesondere von maximal 20°, zueinander auf.

Die geometrische Form der Öffnung 17 und die geometrischen Form des Durchführungsabschnitts 2b sind vorzugsweise zueinander korrespondierend ausgebildet. Die geometrische Form der Öffnung 17 folgt somit der geometrischen Form des Durchführungsabschnitts 2b und umgekehrt.

Beim Ausführungsbeispiel ist die geometrische Form des Durchführungsabschnitts 2b bezüglich einer gedachten in X-Richtung und Z-Richtung sich erstreckenden und durch die ersten und zweiten Außenkanten 4 und 5 verlaufenden zweiten Ebene S2 spiegelsymmetrisch ausgebildet, und ist bezüglich einer gedachten in Y-Richtung und Z-Richtung sich erstreckenden und von der ersten und zweiten Außenkante 4 und 5 identisch beanstandeten ersten Ebene S1 spiegelsymmetrisch ausgebildet.

Die dem ersten Gehäuseteil 13 zugewandte Außenfläche 30 des Durchführungsabschnitts 2b und/oder die dem zweiten Gehäuseteil 14 zugewandte Außenfläche 31 des Durchführungsabschnitts 2b des Lastanschlusselements kann fledermausgaubenförmig ausgebildet sein.

Wie in FIG 5 dargestellt, ist im Rahmen des Ausführungsbeispiels die erste und zweite Außenkante 4 und 5 des Durchführungsabschnitts 2b gegenüber der an den Durchführungsabschnitt 2b angrenzenden lateralen Kontur des Innanschlussabschnitts 2a und des Außenanschlussabschnitts 2c zurückgesetzt. Die erste und zweite Außenkante 4 und 5 des Durchführungsabschnitts 2b ist dabei gegenüber der an den Durchführungsabschnitt 2b angrenzenden lateralen Kontur des Innanschlussabschnitts 2a und des Außenanschlussabschnitts 2c um die Länge f zurückgesetzt. Beim Ausführungsbeispiel liegt die laterale Kontur des Innanschlussabschnitts 2a in Form der lateralen Außenflächen 28 des Innanschlussabschnitts 2a vor und die laterale Kontur des Außenanschlussabschnitts 2c liegt in Form der lateralen Außenflächen 29 des Außenanschlussabschnitts 2c vor. Durch die Zurücksetzung der Außenkanten 4 und 5 können bei der Montage der Leistungshalbleitereinrichtung 1 Beschädigungen der Außenkanten 4 und 5 und Verletzungen von Personen durch die Außenkante 4 und 5 zuverlässig verhindert werden.

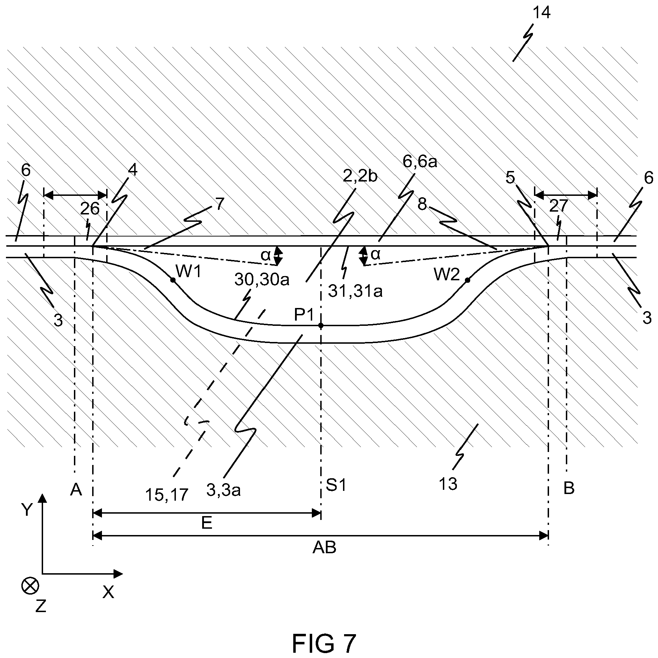

In FIG 7 ist eine Schnittdarstellung eines ersten und zweiten Gehäuseteils 13 und 14 einer weiteren Ausbildung einer erfindungsgemäßen Leistungshalbleitereinrichtung 1, dargestellt, wobei die zwischen dem ersten und zweiten Gehäuseteil 13 und 14 angeordneten Elemente mit dargestellt sind. Die erfindungsgemäße Leistungshalbleitereinrichtung 1 gemäß FIG 7 ist analog der oben beschrieben erfindungsgemäßen Leistungshalbleitereinrichtung 1 gemäß der Figuren 1 bis 6, bis auf das Merkmal, dass das zweite Gehäuseteil 13 keine zweite Ausnehmung aufweist, die über der ersten Ausnehmung 15 angeordnet ist und somit keine zweite Ausnehmung vorhanden ist durch die die Öffnung 17 im Gehäuse der erfindungsgemäßen Leistungshalbleitereinrichtung mit ausgebildet wird, ausgebildet. In FIG 7 sind gleiche Elemente mit den gleichen Bezugszeichen versehen, wie in den Figuren 1 bis 6. Der Durchführungsabschnitt 2b des Lastanschlusselements 2 gemäß FIG 7 entspricht im Rahmens des in FIG 7 dargestellten Ausführungsbeispiels der unteren Hälfte des in den Figuren 4 bis 6 dargestellten Durchführungsabschnitts 2b des Lastanschlusselement 2. Der Kurvenverlauf 31a der dem zweiten Gehäuseteil 14 zugewandten Außenfläche 31 des Durchführungsabschnitts 2b gemäß FIG 7 ist vorzugsweise zu einer Geraden reduziert. Die dem ersten Gehäuseteil 13 zugewandte Außenfläche 30 und die dem zweiten Gehäuseteil 14 zugewandte Außenfläche 31 weisen an der ersten und zweiten Außenkante 4 und 5 vorzugsweise einen Wickel α von maximal 30°, insbesondere von maximal 20°, insbesondere von maximal 15° und insbesondere von maximal 10° zueinander auf.
Es sei an dieser Stelle angemerkt, das selbstverständlich Merkmale von verschiedenen Ausführungsbeispielen der Erfindung, sofern sich die Merkmale nicht gegenseitig ausschließen, beliebig miteinander kombiniert werden können, solange solche Kombinationen im Einklang mit den vorliegenden Patentansprüchen stehen.

## Patentansprüche

1. Leistungshalbleitereinrichtung mit einem Substrat (19) und mit auf dem Substrat (19) angeordneten und mit dem Substrat (19) verbundenen Leistungshalbleiterbauelementen (22), wobei die Leistungshalbleitereinrichtung (1) ein Gehäuse (32) aufweist, das eine erste Ausnehmung (15) aufweisendes erstes Gehäuseteil (13) und ein zweites Gehäuseteil (14) aufweist, wobei das zweite Gehäuseteil (14) derart zum ersten Gehäuseteil (13) angeordnet ist, dass sich durch die erste Ausnehmung (15) eine Öffnung (17) im Gehäuse (32) ausbildet, wobei die Leistungshalbleitereinrichtung (1) zur elektrischen Kontaktierung der Leistungshalbleitereinrichtung (1) ein elektrisch leitendes Lastanschlusselement (2) aufweist, das einen außerhalb des Gehäuses (32) angeordneten Außenanschlussabschnitt (2c) und einen innerhalb des Gehäuses (32) angeordneten Innenanschlussabschnitt (2a) und einen durch die Öffnung (17) durchlaufenden Durchführungsabschnitt (2b) aufweist, wobei der Durchführungsabschnitt (2b) einen lateral in Richtung einer ersten Außenkante (4) des Durchführungsabschnitts (2b) spitz zulaufenden ersten Außenkantenbereich (7) und einen lateral in Richtung einer zweiten Außenkante (5) des Durchführungsabschnitts (2b) spitz zulaufenden zweiten Außenkantenbereich (8) aufweist, wobei der erste und zweite Außenkantenbereich (7,8) voneinander abgewandt angeordnet sind und die erste Außenkante (4) im Bereich (26) des lateralen ersten Endes (A) der Öffnung (17) und die zweite Außenkante (5) im Bereich (27) des lateralen zweiten Endes (B) der Öffnung (17) angeordnet ist, wobei zwischen dem ersten Gehäuseteil (13) und dem Durchführungsabschnitt (2b) ein erster Abschnitt (3a) eines ersten Dichtelements (3) und zwischen dem zweiten Gehäuseteil (14) und dem Durchführungsabschnitt (2b) ein erster Abschnitt (6a) eines zweiten Dichtelements (6) angeordnet ist, wobei das erste und zweite Dichtelement (3,6) lateral von der ersten und zweiten Außenkante (4,5) einen Kontakt zueinander aufweisen, wobei das erste Dichtelement (3) den Durchführungsabschnitt (2b) gegen das erste Gehäuseteil (13) abdichtet und das zweite Dichtelement (6) den Durchführungsabschnitt (2b) gegen das zweite Gehäuseteil (14) abdichtet.

2. Leistungshalbleitereinrichtung nach einem Ansprüche 1, **dadurch gekennzeichnet, dass** die geometrische Form des Durchführungsabschnitts (2b) durch eine dem ersten Gehäuseteil (13) zugewandte Außenfläche (30) des Durchführungsabschnitts (2b) und durch eine dem zweiten Gehäuseteil (14) zugewandte Außenfläche (31) des Durchführungsabschnitts (2b) gebildet wird, wobei die dem ersten Gehäuseteil (13) zugewandte Außenfläche (30) im Bereich (AB) zwischen erster und zweiter Außenkante (4,5) in Richtung von der ersten zur zweiten Außenkante einen zwei Wendepunkte (W1,W2) aufweisenden Kurvenverlauf (30a) aufweist, wobei der erste Wendepunkt (W1) zwischen erster Außenkante (4) und einem Punkt (P1) des Kurvenverlaufs (30a), dessen senkrechte Entfernung (E) zur ersten Außenkante (4) dem halben Abstand der ersten und zweiten Außenkante (4,5) voneinander entspricht, angeordnet ist, wobei der zweite Wendepunkt (W2) zwischen zweiter Außenkante (5) und dem Punkt (P1) des Kurvenverlaufs (30a) dessen senkrechte Entfernung (E) zur ersten Außenkante (4) dem halben Abstand der ersten und zweiten Außenkante (4,5) voneinander entspricht, angeordnet ist.

3. Leistungshalbleitereinrichtung nach einem der vorhergehenden Ansprüche, **dadurch gekennzeichnet, dass** die geometrische Form des Durchführungsabschnitts (2b) bezüglich einer gedachten in Y-Richtung und Z-Richtung sich erstreckenden und von der ersten und zweiten Außenkante (4,5) identisch beanstandeten ersten Ebene (S1) spiegelsymmetrisch ausgebildet ist.

4. Leistungshalbleitereinrichtung nach Anspruch 1, **dadurch gekennzeichnet, dass** das zweite Gehäuseteil (14) eine zweite Ausnehmung (16) aufweist, wobei das zweite Gehäuseteil (14) derart zum ersten Gehäuseteil (13) angeordnet ist, dass die zweite Ausnehmung (16) über der ersten Ausnehmung (15) angeordnet ist und sich durch die erste und zweite Ausnehmung (15,16) die Öffnung (17) im Gehäuse ausbildet.

5. Leistungshalbleitereinrichtung nach einem Ansprüche 4, **dadurch gekennzeichnet, dass** die geometrische Form des Durchführungsabschnitts (2b) durch eine dem ersten Gehäuseteil (13) zugewandte Außenfläche (30) des Durchführungsabschnitts (2b) und durch eine dem zweiten Gehäuseteil (14) zugewandte Außenfläche (31) des Durchführungsabschnitts (2b) gebildet wird wobei die dem ersten Gehäuseteil (13) zugewandte Außenfläche (30) und die dem zweiten Gehäuseteil (14) zugewandte Außenfläche (31) im Bereich (AB) zwischen erster und zweiter Außenkante (4,5) in Richtung von der ersten zur zweiten Außenkante einen zwei Wendepunkte (W1,W2,W3,W4) aufweisenden jeweiligen Kurvenverlauf (30a,31a) aufweist, wobei der jeweilige erste Wendepunkt (W1,W3) zwischen erster Außenkante (4) und einem Punkt (P1,P2) des jeweiligen Kurvenverlaufs (30a,31a), dessen senkrechte Entfernung zur ersten Außenkante (4) dem halben Abstand der ersten und zweiten Außenkante (4,5) voneinander entspricht, angeordnet ist, wobei der jeweilige zweite Wendepunkt (W2,W4) zwischen zweiter Außenkante (5) und dem Punkt (P1,P2) des jeweiligen Kurvenverlaufs (30a,31a) dessen senkrechte Entfernung (E) zur ersten Außenkante (4) dem halben Abstand der ersten und zweiten Außenkante (4,5) voneinander entspricht, angeordnet ist.

6. Leistungshalbleitereinrichtung nach einem der Ansprüche 4 oder 5, **dadurch gekennzeichnet, dass** die geometrische Form des Durchführungsabschnitts (2b) bezüglich einer gedachten in X-Richtung und Z-Richtung sich erstreckenden durch die ersten und zweiten Außenkanten (4,5) verlaufenden zweiten Ebene (S2) spiegelsymmetrisch ausgebildet ist, und bezüglich einer gedachten in Y-Richtung und Z-Richtung sich erstreckenden und von der ersten und zweiten Außenkante (4,5) identisch beanstandeten ersten Ebene (S1) spiegelsymmetrisch ausgebildet ist.

7. Leistungshalbleitereinrichtung nach einem der vorhergehenden Ansprüche, **dadurch gekennzeichnet, dass** die geometrische Form des Durchführungsabschnitts (2b) durch eine dem ersten Gehäuseteil (13) zugewandte Außenfläche (30) des Durchführungsabschnitts (2b) und durch eine dem zweiten Gehäuseteil (14) zugewandte Außenfläche (31) des Durchführungsabschnitts (2b) gebildet wird, wobei die dem ersten Gehäuseteil (13) zugewandte und die dem zweiten Gehäuseteil (14) zugewandte Außenfläche (30,31) im Bereich (AB) zwischen erster und zweiter Außenkante (4,5) in Richtung von der ersten zur zweiten Außenkante einen stetig differenzierbaren Kurvenverlauf aufweist.

8. Leistungshalbleitereinrichtung nach einem der vorhergehenden Ansprüche, **dadurch gekennzeichnet, dass** die geometrische Form des Durchführungsabschnitts (2b) durch eine dem ersten Gehäuseteil (13) zugewandte Außenfläche (30) des Durchführungsabschnitts (2b) und durch eine dem zweiten Gehäuseteil (14) zugewandte Außenfläche (31) des Durchführungsabschnitts (2b) gebildet wird, wobei die dem ersten Gehäuseteil (13) zugewandte Außenfläche (30) und die dem zweiten Gehäuseteil (14) zugewandte Außenfläche (31) an der ersten und zweiten Außenkante (4,5) einen Wickel (α) von maximal 30° zueinander aufweisen.

9. Leistungshalbleitereinrichtung nach einem der vorhergehenden Ansprüche, **dadurch gekennzeichnet, dass** die geometrische Form der Öffnung (17) und die geometrischen Form des Durchführungsabschnitts (2b) zueinander korrespondierend ausgebildet sind.

10. Leistungshalbleitereinrichtung nach einem der vorhergehenden Ansprüche, **dadurch gekennzeichnet, dass** die erste und zweite Außenkante (4,5) des Durchführungsabschnitts (2b) gegenüber der an den Durchführungsabschnitt (2b) angrenzenden lateralen Kontur (28,29) des Innenanschlussabschnitts (2a) und des Außenanschlussabschnitts (2b) zurückgesetzt ist.

11. Leistungshalbleitereinrichtung nach einem der vorhergehenden Ansprüche, **dadurch gekennzeichnet, dass** das erste Dichtelement (3) stoffschlüssig mit dem ersten Gehäuseteil (13) verbunden ist und/oder das zweite Dichtelement (6) stoffschlüssig mit dem zweiten Gehäuseteil (14) verbunden ist.

## Claims

1. Power semiconductor device comprising a substrate (19) and comprising power semiconductor components (22) arranged on the substrate (19) and connected to the substrate (19), wherein the power semiconductor device (1) has a housing (32), which has a first housing part (13) having a first cutout (15) and a second housing part (14), wherein the second housing part (14) is arranged relative to the first housing part (13) in such a way that an opening (17) in the housing (32) forms through the first cutout (15), wherein the power semiconductor device (1) has an electrically conductive load terminal element (2) for the purpose of making electrical contact with the power semiconductor device (1), said load terminal element having an external terminal section (2c) arranged outside the housing (32) and an internal terminal section (2a) arranged within the housing (32) and a feedthrough section (2b) pressing through the opening (17), wherein the feedthrough section (2b) has a first outer edge region (7) tapering laterally in the direction of a first outer edge (4) of the feedthrough section (2b) and a second outer edge region (8) tapering laterally in the direction of a second outer edge (5) of the feedthrough section (2b) wherein the first and second outer edge regions (7, 8) are arranged in a manner facing away from one another and the first outer edge (4) is arranged in the region (26) of the lateral first end (A) of the opening (17) and the second outer edge (5) is arranged in the region (27) of the lateral second end (B) of the opening (17), wherein a first section (3a) of a first sealing element (3) is arranged between the first part (13) and the feedthrough section (2b) and a first section (6a) of a second sealing element (6) is arranged between the second housing part (14) and the feedthrough section (2b), wherein the first and second sealing elements (3, 6) have a contact with one another laterally from the first and second outer edges (4, 5), wherein the first sealing element (3) seals the feedthrough section (2b) with respect to the first housing part (13) and the second sealing element (6) seals the feedthrough section (2b) with respect to the second housing part (14).

2. Power semiconductor device according to any of Claims 1, **characterized in that** the geometrical shape of the feedthrough section (2b) is formed by an outer surface (30) of the feedthrough section (2b) facing the first housing part (13) and by an outer surface (31) of the feedthrough section (2b) facing the second housing part (14), wherein the outer surface (30) facing the first housing part (13) has a curve course (30a) having two turning points (W1, W2) in the region (AB) between first and second outer edges (4, 5) in the direction from the first to the second outer edge, wherein the first turning point (W1) is arranged between the first outer edge (4) and a point (P1) of the curve course (30a) whose perpendicular distance (E) from the first outer edge (4) corresponds to half the distance between the first and second outer edges (4, 5), wherein the second turning point (W2) is arranged between the second outer edge (5) and the point (P1) of the curve course (30a) whose perpendicular distance (E) from the first outer edge (4) corresponds to half the distance between the first and second outer edges (4, 5).

3. Power semiconductor device according to either of the preceding claims, **characterized in that** the geometrical shape of the feedthrough section (2b) is embodied such that it is mirror-symmetrical relative to an imaginary first plane (S1) that extends in the Y-direction and Z-direction and is spaced apart identically from the first and second outer edges (4, 5) .

4. Power semiconductor device according to Claim 1, **characterized in that** the second housing part (14) has a second cutout (16), wherein the second housing part (14) is arranged in relation to the first housing part (13) in such a way that the second cutout (16) is arranged above the first cutout (15) and the opening (17) in the housing forms through the first and second cutouts (15, 16) .

5. Power semiconductor device according to any of Claims 4, **characterized in that** the geometrical shape of the feedthrough section (2b) is formed by an outer surface (30) of the feedthrough section (2b) facing the first housing part (13) and of an outer surface (31) of the feedthrough section (2b) facing the second housing part (14), wherein the outer surface (30) facing the first housing part (13) and the outer surface (31) facing the second housing part (14) have a respective curve course (30a), 31a) having two turning points (W1, W2, W3, W4) in the region (AB) between first and second outer edges (4, 5) in the direction from the first to the second outer edge, wherein the respective first turning point (W1, W3) is arranged between the first outer edge (4) and a point (PI, P2) of the respective curve course (30a, 31a) whose perpendicular distance from the first outer edge (4) corresponds to half the distance between the first and second outer edges (4, 5), and the respective second turning point (W2, W4) is arranged between the second outer edge (5) and point (PI, P2) of the respective curve course (30a, 31a) whose perpendicular distance (E) from the first outer edge (4) corresponds to half the distance between the first and second outer edges (4, 5).

6. Power semiconductor device according to either of Claims 4 and 5, **characterized in that** the geometrical shape of the feedthrough section (2b) is embodied such that it is mirror-symmetrical relative to an imaginary second plane (S2) that extends in the X-direction and Z-direction and runs through the first and second outer edges (4, 5), and is embodied such that it is mirror-symmetrical relative to an imaginary first plane (S1) that extends in the Y-direction and Z-direction and is spaced apart identically from the first and second outer edges (4, 5).

7. Power semiconductor device according to any of the preceding claims, **characterized in that** the geometrical shape of the feedthrough section (2b) is formed by an outer surface (30) of the feedthrough section (2b) facing the first housing part (13) and by an outer surface (31) of the feedthrough section (2b) facing the second housing part (14), wherein the outer surfaces (30, 31) facing the first housing part (13) and the second housing part (14) have a continuously differentiable curve course in the region (AB) between first and second outer edges (4, 5) in the direction from the first to the second outer edge.

8. Power semiconductor device according to any of the preceding claims, **characterized in that** the geometrical shape of the feedthrough section (2b) is formed by an outer surface (30) of the feedthrough section (2b) facing the first housing part (13) and by an outer surface (31) of the feedthrough section (2b) facing the second housing part (14) wherein the outer surface (30) facing the first housing part (13) and the outer surface (31) facing the second housing part (14) are at an angle (α) of a maximum of 30° with respect to one another at the first and second outer edges (4, 5) .

9. Power semiconductor device according to any of the preceding claims, **characterized in that** the geometrical shape of the opening (17) and the geometrical shape of the feedthrough section (2b) are embodied such that they correspond to one another.

10. Power semiconductor device according to any of the preceding claims, **characterized in that** the first and second outer edges (4, 5) of the feedthrough section (2b) are set back relative to that lateral contour (28, 29) of the internal terminal section (2a) and of the external terminal section (2b) which adjoins the feedthrough section (2b).

11. Power semiconductor device according to any of the preceding claims, **characterized in that** the first sealing element (3) is cohesively connected to the first housing part (13) and/or the second sealing element (6) is cohesively connected to the second housing part (14).

## Revendications

1. Dispositif semi-conducteur de puissance pourvu d'un substrat (19) et de composants semiconducteurs de puissance (22) placés sur le substrat (19) et reliés avec le substrat (19), le dispositif semi-conducteur de puissance (1) comportant un boîtier (32) lequel comporte une première partie de boîtier (13) dotée d'un premier évidement (15) et une deuxième partie de boîtier (14), la deuxième partie de boîtier (14) étant placée par rapport à la première partie de boîtier (13) de telle sorte qu'à travers le premier évidement (15) se forme un orifice (17) dans le boîtier (32), pour la mise en contact électrique du dispositif semi-conducteur de puissance (1), le dispositif semi-conducteur de puissance (1) comportant une borne de charge (2) conductrice d'électricité, qui comporte un segment de raccordement extérieur (2c) placé à l'extérieur du boîtier (32) et un segment de raccordement intérieur (2a) placé à l'intérieur du boîtier (32) et un segment de passage (2b) traversant l'orifice (17), le segment de passage (2b) comportant une première zone d'arête extérieure (7) s'étendant latéralement en pointe dans la direction d'une première arête extérieure (4) du segment de passage (2b) et une deuxième zone d'arête extérieure (8) s'étendant latéralement en pointe dans la direction d'une deuxième arête extérieure (5) du segment de passage (2b), la première et la deuxième zones d'arête extérieure (7, 8) étant placées en étant mutuellement opposées et la première arête extérieure (4) étant placée dans la zone (26) de la première extrémité latérale (A) de l'orifice (17) et la deuxième arête extérieure (5) étant placée dans la zone (27) de la deuxième extrémité latérale (B) de l'orifice (17), entre la première partie de boîtier (13) et le segment de passage (2b) étant placé un premier segment (3a) d'un premier élément d'étanchéité (3) et entre la deuxième partie de boîtier (14) et le segment de passage (2b) étant placé un deuxième segment (6a) d'un deuxième élément d'étanchéité (6), le premier et le deuxième éléments d'étanchéité (3, 6) comportant latéralement de la première et de la deuxième arêtes extérieures (4, 5) un contact mutuel, le premier élément d'étanchéité (3) assurant l'étanchéité du segment de passage (2b) contre la première partie de boîtier (13) et le deuxième élément d'étanchéité (6) assurant l'étanchéité du segment de passage (2b) contre la deuxième partie de boîtier (14).

2. Dispositif semi-conducteur de puissance selon la l'une quelconque des revendications 1, **caractérisé en ce que** la forme géométrique du segment de passage (2b) est formée par une surface extérieure (30) du segment de passage (2b) qui fait face à la première partie de boîtier (13) et par une surface extérieure (31) du segment de passage (2b) qui fait face à la deuxième partie de boîtier (14), dans la zone (AB) entre la première et la deuxième arêtes extérieures (4, 5), dans la direction de la première vers la deuxième arête extérieure, la surface extérieure (30) qui fait face à la première partie de boîtier (13) présentant un tracé en courbe (30a) comportant deux virages (W1, W2), le premier virage (W1) étant placé entre la première arête extérieure (4) et un point (P1) du tracé en courbe (30a), dont l'éloignement perpendiculaire (E) par rapport à la première arête extérieure (4) correspond au demi-écart mutuel entre la première et la deuxième arêtes extérieures (4, 5), le deuxième virage (W2) étant placé entre la deuxième arête extérieure (5) et le point (P1) du tracé en courbe (30a) dont l'éloignement perpendiculaire (E) par rapport à la première arête extérieure (4) correspond au demi-écart mutuel entre la première et la deuxième arêtes extérieures (4, 5).

3. Dispositif semi-conducteur de puissance selon l'une quelconque des revendications précédentes, **caractérisé en ce que** la forme géométrique du segment de passage (2b) est conçue en symétrie spéculaire par rapport à un premier plan (S1) imaginaire s'étendant dans la direction Y et dans la direction Z et écarté de manière identique de la première et de la deuxième arêtes extérieures (4, 5).

4. Dispositif semi-conducteur de puissance selon la revendication 1, **caractérisé en ce que** la deuxième partie de boîtier (14) comporte un deuxième évidement (16), la deuxième partie de boîtier (14) étant placée par rapport à la première partie de boîtier (13) de telle sorte, que le deuxième évidement (16) soit placé au-dessus du premier évidement (15) et que l'orifice (17) se forme dans le boîtier à travers le premier et le deuxième évidements (15, 16).

5. Dispositif semi-conducteur de puissance selon l'une quelconque des revendications 4, **caractérisé en ce que** la forme géométrique du segment de passage (2b) est formée par une surface extérieure (30) du segment de passage (2b) qui fait face à la première partie de boîtier (13) et par une surface extérieure (31) du segment de passage (2b) qui fait face à la deuxième partie de boîtier (14), dans la zone (AB) entre la première et la deuxième arêtes extérieures (4, 5), la surface extérieure (30) qui fait face à la première partie de boîtier (13) et la surface extérieure (31) qui fait face à la deuxième partie de boîtier (14) présentant dans la direction de la première vers la deuxième arête extérieure un tracé en courbe (30a, 31a) respectif comportant deux virages (W1, W2, W3, W4), le premier virage (W1, W3) respectif étant placé entre la première arête extérieure (4) et un point (P1, P2) du tracé en courbe (30a, 31a) respectif, dont l'éloignement perpendiculaire par rapport à la première arête extérieure (4) correspond au demi-écart entre la première et la deuxième arêtes extérieures (4, 5), le deuxième virage (W2, W4) respectif étant placé entre la deuxième arête extérieure (5) et le point (P1, P2) du tracé en courbe (30a, 31a) respectif dont l'éloignement perpendiculaire (E) par rapport à la première arête extérieure (4) correspond au demi-écart entre la première et la deuxième arêtes extérieures (4, 5).

6. Dispositif semi-conducteur de puissance selon l'une quelconque des revendications 4 ou 5, **caractérisé en ce que** la forme géométrique du segment de passage (2b) est conçue en symétrique spéculaire par rapport à un deuxième plan (S2) imaginaire s'étendant dans la direction X et dans la direction Z, s'écoulant à travers la première et la deuxième arêtes extérieures (4, 5), et est conçue en symétrie spéculaire par rapport à un premier plan (S1) imaginaire, s'étendant dans la direction Y et dans la direction Z et écarté de manière identique de la première et de la deuxième arêtes extérieures (4, 5).

7. Dispositif semi-conducteur de puissance selon l'une quelconque des revendications précédentes, **caractérisé en ce que** la forme géométrique du segment de passage (2b) est formée par une surface extérieure (30) du segment de passage (2b) qui fait face à la première partie de boîtier (13) et par une surface extérieure (31) du segment de passage (2b) qui fait face à la deuxième partie de boîtier (14), dans la zone (AB) entre la première et la deuxième arêtes extérieures (4, 5), les surfaces extérieures (30, 31) faisant face à la première partie de boîtier (13) et faisant face à la deuxième partie de boîtier (14) comportant dans la direction de la première vers la deuxième arête extérieure un tracé en courbe constamment différenciable.

8. Dispositif semi-conducteur de puissance selon l'une quelconque des revendications précédentes, **caractérisé en ce que** la forme géométrique du segment de passages (2b) est formée par une surface extérieure (30) du segment de passage (2b) qui fait face à la première partie de boîtier (13) et par une surface extérieure (31) du segment de passage (2b) qui fait face à la deuxième partie de boîtier (14), sur la première et sur la deuxième arêtes extérieures (4, 5), la surface extérieure (30) qui fait face à la première partie de boîtier (13) et la surface extérieure (31) qui fait face à la deuxième partie de boîtier (14) présentant l'une par rapport à l'autre un angle (α) mutuel d'un maximum de 30°.

9. Dispositif semi-conducteur de puissance selon l'une quelconque des revendications précédentes, **caractérisé en ce que** la forme géométrique de l'orifice (17) et la forme géométrique du segment de passage (2b) sont conçues en correspondance mutuelle.

10. Dispositif semi-conducteur de puissance selon l'une quelconque des revendications précédentes, **caractérisé en ce que** la première et la deuxième arêtes extérieures (4, 5) du segment de passage (2b) sont en retrait par rapport au contour latéral (28, 29) du segment de raccordement intérieur (2a) et du segment de raccordement extérieur (2b) qui sont adjacents au segment de passage (2b).

11. Dispositif semi-conducteur de puissance selon l'une quelconque des revendications précédentes, **caractérisé en ce que** le premier élément d'étanchéité (3) est relié par matière avec la première partie de boîtier (13) et/ou **en ce que** le deuxième élément d'étanchéité (6) est relié par matière avec la deuxième partie de boîtier (14).
